# EUROPÄISCHE PATENTANMELDUNG

(11) **EP 3 082 011 A1**
(43) Veröffentlichungstag der Anmeldung: **19.10.2016**
(21) Anmeldenummer: 16165261.5
(22) Anmeldetag: 14.04.2016
(51) Int. Cl.: G05D 23/19, G01N 27/12, G05D 23/24

(54) **ANORDNUNG UND VERFAHREN ZUR MESSUNG UND STEUERUNG DER HEIZTEMPERATUR IN EINEM HALBLEITER-GASSENSOR**

(30) Priorität: 17.04.2015 DE 102015105871
(71) Anmelder: Zentrum Mikroelektronik Dresden AG, 01109 Dresden (DE)
(72) Erfinder: GEORGI, Michael, 01705 Freital (DE); SCHREIBER, Ronald, 01705 Freital (DE)
(74) Vertreter: Lippert, Stachow & Partner

(57) **Zusammenfassung**

Die Erfindung betrifft eine Anordnung zur Steuerung der Heiztemperatur für einen Halbleiter-Gassensor umfassend einen Regelkreis, bestehend aus einem Heizwiderstand als Regelstrecke einer eine die Temperatur des Heizwiderstandes repräsentierende physikalische Größe messende Messeinrichtung, und einer eine Energieversorgung des Heizwiderstandes steuernde Stelleinrichtung und ein Verfahren, welches die Anordnung nutzt. Die Aufgabe eine einfache Steuerungsschaltung des Heizwiderstandes mit hohem elektrischen Wirkungsgrad anzugeben, wird dadurch gelöst, dass die Stelleinrichtung aus einer pulsierenden Spannungsquelle besteht, die eine erste Pulsdauer aufweist, während der Heizwiderstand mit einer Betriebsspannung verbunden ist und einer zweiten Pulsdauer, während der der Heizwiderstand von der Betriebsspannung getrennt ist, deren erste und/oder zweite Pulsdauer als Stellgröße steuerbar ist, und dass eine den Heizwiderstand während der zweiten Pulsdauer mit einem Messstrom beaufschlagenden Konstant-Stromquelle und eine die über den Heizwiderstand abfallende Messspannung messende Messeinrichtung vorgesehen ist, deren Ausgang als Regelgrößenrückführung in dem Regelkreis ausgebildet ist.

## Beschreibung

Die Erfindung betrifft eine Anordnung zur Steuerung der Heiztemperatur in einem Halbleiter-Gassensor umfassend einen Regelkreis, bestehend aus einem Heizwiderstand als Regelstrecke einer eine die Temperatur des Heizwiderstandes repräsentierende physikalische Größe messende Messeinrichtung, und einer eine Energieversorgung des Heizwiderstandes steuernde Stelleinrichtung.

Die Erfindung betrifft auch ein Verfahren zur Messung und Steuerung der Heiztemperatur eines Heizwiderstandes in einem Halbleiter-Gassensor.

Halbleiter-Gassensoren, die auch Metalloxid-Halbleitergassensoren (kurz: MOX) genannt werden, sind elektrische Leitfähigkeitssensoren. Sie bestehen aus einem Sensorwiderstand, der auf eine Arbeitstemperatur geheizt werden muss. Der Widerstand ihrer sensorisch aktiven Schicht ändert sich beim Kontakt mit dem zu detektierenden Gas. Dabei geht das Gas eine, im Idealfall vollständig reversible, Reaktion mit der Sensoroberfläche ein. Durch ihre chemische Beschaffenheit eignen sich Metalloxid-Gassensoren für einen breiten Anwendungsbereich und die Detektion aller reaktiven Gase. Abhängig von den verwendeten Materialien und den zu detektierenden Gasen sind Betriebstemperaturen zwischen 300°C und 900°C üblich.

Die Einsatzbereiche von Halbleiter-Gassensoren sind sehr vielfältig und reichen von der Sicherheitstechnik (Explosions-, Leckage-, Brand- und Vergiftungsschutz) über Emissions- und Luftgüteüberwachung bis hin zur Qualitätssicherung und Prozessmesstechnik. Der Messbereich ist abhängig vom zu detektierenden Gas und reicht von wenigen ppb bis in den Prozentbereich. Die Nachweisgrenze ist abhängig vom gassensitiven Material. Die Betriebstemperaturen sind ebenfalls jeweils abhängig vom Material der sensitiven Schicht und dem optimalen Ansprechverhalten der Sensoren.

Die Arbeitstemperatur, auf die der Sensorwiderstand geheizt werden muss, hat auch Einfluss auf die Empfindlichkeit und die Selektivität des Sensorwiderstandes und muss deshalb möglichst genau eingestellt werden. Eine gute Selektivität bedeutet bei einem Gassensor, dass seine Sensorreaktion auf eine Zielsubstanz, z.B. ein zu detektierendes Gas gerichtet ist und nur dieses detektiert. Üblicherweise wird das Heizen durch einen Heizwiderstand übernommen, welcher thermisch gut mit dem Sensorwiderstand gekoppelt ist. Für das Messen der Arbeitstemperatur verwendet man entweder einen separaten Temperatursensor oder man nutzt die Temperaturabhängigkeit des Heizwiderstandes. Beispielsweise kann der Heizwiderstand aus Platin hergestellt werden und hat dann eine genau definierte Temperaturabhängigkeit. In der vorliegenden Erfindung wird kein separater Temperatursensor verwendet, sondern der Heizwiderstand wird sowohl zum Heizen als auch zum Messen der Arbeitstemperatur genutzt.

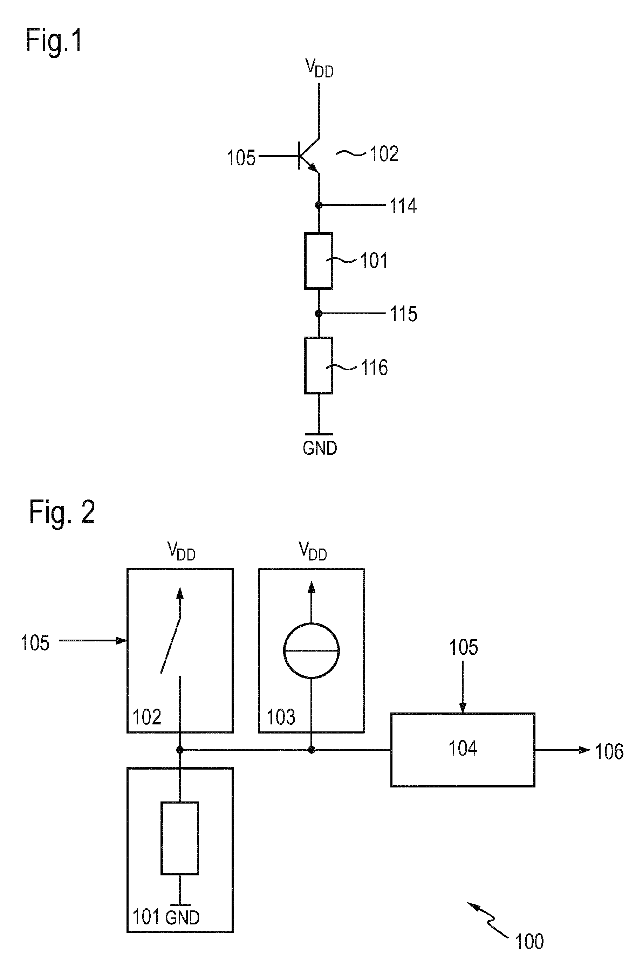

Die Temperatur des Heizwiderstandes kann über die elektrische Leistung des Widerstandes gesteuert werden. Dafür sind verschiedene Methoden bekannt:
Man kann mit einem analogen Stellelement die Spannung über oder den Strom durch den Heizwiderstand einstellen. Dabei entsteht über dem analogen Stellelement ein Leistungsverlust, der den elektrischen Wirkungsgrad der Anordnung verschlechtert. Eine beispielhafte Anordnung ist in Figur 1 dargestellt. Als analoges Stellelement wird z.B. ein Transistor oder ein Potentiometer verwendet. Ein Shunt-Widerstand 116 mit einem sehr kleinen Widerstandswert dient zur Strommessung 115. Gleichzeitig wird das Messsignal für den Heizstrom und die Heizspannung 114 abgegriffen.

Eine weitere Methode besteht darin, dass mit einem digitalen Stellelement die Spannung über oder der Strom durch den Heizwiderstand ein- und ausgeschaltet wird, so dass sich aus der An- und Aus-Zeit die gewünschte mittlere Leistung ergibt. Das Ein- und Ausschalten kann in Form einer Pulsbreiten- oder einer Pulsdichte-Modulation erfolgen. Im Idealfall hat das Stellelement durch den digitalen Betrieb keine eigene Verlustleistung und es kann ein sehr hoher elektrischer Wirkungsgrad erzielt werden.

Zum Heizen muss an dem Heizwiderstand eine Spannung anliegen und ein Strom fließen. Die sich daraus ergebende elektrische Leistung wird im Heizwiderstand in Wärme umgewandelt und führt zur Erwärmung des Heizwiderstandes, der den Sensorwiderstand erwärmt. Um die elektrische Leistung (und damit die Temperatur des Heizwiderstandes bzw. Sensorwiderstandes) steuern zu können, muss entweder die Spannung über dem Heizwiderstand oder der Strom durch den Heizwiderstand gesteuert werden.

Für die Messung der Temperatur muss der Widerstandswert des Heizwiderstandes gemessen werden. Denn der Widerstandswert ist ein Maß für die Temperatur des Sensorwiderstandes. Dazu müssen jedoch die Spannung über dem Heizwiderstand und der Strom durch den Heizwiderstand bekannt sein oder gemessen werden.

Bekannte Ansteuerschaltungen, die das Heizen und Temperaturmessen erlaubt, sind aber sehr komplex und haben nur einen geringen elektrischen Wirkungsgrad. Die beispielhafte in Figur 1 dargestellte Schaltung ist zwar einfach aufgebaut, hat allerdings einen schlechten Wirkungsgrad aufgrund der hohen Verlustleistung des analogen Steuerelements und des Shunt-Widerstandes. Ein digitales Stellelement hätte zwar keine eigene Verlustleistung, die Messung des Heizwiderstandes wäre jedoch sehr kompliziert: Zum einen müsste der Strom durch den Heizer während der An-Zeit gemessen werden, bspw. mittels eines Shunt-Widerstands, dieser würde aber den Leistungswirkungsgrad wieder verschlechtern. Zum anderen müsste zusätzlich die Spannung über dem Heizwiderstand während der An-Zeit bekannt sein. Diese ergäbe sich aus der (unbekannten) Betriebsspannung minus dem (unbekannten) Spannungsabfall über dem digitalen Stellelement minus dem Spannungsabfall über dem Shunt-Widerstand.

Es ist daher die Aufgabe der vorliegenden Erfindung eine Ansteuerschaltung für einen Heizwiderstand in einem Halbleiter-Gassensor anzugeben, die die bisherigen Nachteile aus dem Stand der Technik beseitigt und eine einfache Steuerung der elektrischen Leistung des Heizwiderstandes erlaubt, den Widerstandswert des Heizwiderstandes messen kann und einen hohen elektrischen Wirkungsgrad aufweist. Gerade für den mobilen Einsatz ist eine Schaltung mit einer geringen Verlustleistung besonders wichtig.

Gleichzeitig sollen die Temperatur des Heizwiderstandes und damit die Temperatur des Sensorwiderstandes des Halbleiter-Gassensors exakt entsprechend den Messanforderungen anpassbar sein. Diese Temperaturanpassung soll auch dann exakt anpassbar sein, wenn die Betriebsspannung V_{DD} der Anordnung nicht vorhersehbaren Schwankungen unterliegt. Daher ist eine messtechnische Entkopplung von der Betriebsspannung V_{DD} besonders wichtig.

Die Aufgabe der Erfindung wird anordnungsseitig dadurch gelöst, dass die Stelleinrichtung aus einer pulsierenden Spannungsquelle besteht, die eine erste Pulsdauer aufweist, während der Heizwiderstand mit einer Betriebsspannung V_{DD} verbunden ist und einer zweiten Pulsdauer, während der der Heizwiderstand von der Betriebsspannung V_{DD} getrennt ist, deren erste und/oder zweite Pulsdauer als Stellgröße steuerbar ist, und dass eine den Heizwiderstand während der zweiten Pulsdauer mit einem Messstrom beaufschlagenden Konstant-Stromquelle und eine die über den Heizwiderstand abfallende Messspannung messende Messeinrichtung vorgesehen ist, deren Ausgang als Regelgrößenrückführung in dem Regelkreis ausgebildet ist. Die Stelleinrichtung dient dazu, den Heizwiderstand während einer ersten Pulsdauer (An-Zeit der Stelleinrichtung) mit der Energieversorgung zu verbinden, d.h. es wird eine Spannung angelegt und es fließt ein Strom durch den Heizwiderstand, welcher dadurch erwärmt also geheizt wird. Die Spannung V_{DD} ist nicht konstant, sondern unterliegt Schwankungen, die bei der Heizung des Heizwiderstandes berücksichtigt werden müssen. Während der zweiten Pulsdauer (Aus-Zeit der Stelleinrichtung) wird der Heizwiderstand von der Energieversorgung getrennt und ist nun mit einer Konstant-Stromquelle verbunden, die einen bekannten Messstrom durch den Heizwiderstand schickt, wobei in dieser Zeit mittels der Messeinrichtung der vom Messstrom erzeugte Spannungsabfall über dem Heizwiderstand gemessen wird. Der durch den Messstrom hervorgerufene Spannungsabfall während der Aus-Zeit ist ein Maß für den Widerstandswert des Heizwiderstandes und damit ein Maß für die Temperatur des Sensorwiderstandes. Dadurch wird die Messung des Heizwiderstandes von der restlichen Anordnung entkoppelt und unterliegt nicht mehr der schwankenden Spannung V_{DD} der Energieversorgung. Die Messeinrichtung ist als Spannungsmessschaltung ausgebildet und kann aus dem Messsignal ein Signal erzeugen, welches der Temperatur des Heizwiderstandes und damit der Temperatur des Sensorwiderstandes entspricht. Dieses Signal stellt die Regelgröße in dem durch Stelleinrichtung und Messeinrichtung gebildeten Regelkreises dar, so dass damit durch die Ansteuerung der Stelleinrichtung, die Temperatur des Sensorwiderstandes exakt einstellbar ist. Durch das Anlegen eines konstanten Messstromes muss für die Bestimmung der Leistung durch den Heizwiderstand nur noch die Spannung über dem Heizwiderstand gemessen werden. Durch diese Anordnung ist dies mit einem hohen elektrischen Wirkungsgrad realisierbar, da nahezu keine Verluste bei dieser Schaltungs- und Messanordnung auftreten. Denn erstens wird auf ein bisher in solchen Messanordnungen verwendetes analoges Stellelement verzichtet, welches die größte Verlustquelle darstellt, und etwa 70% der Gesamtleistung verbrauchen würde, und zweitens wird keinen Shunt-Widerstand genutzt, der je nach Dimensionierung etwa 10% Leistungsverlust erzeugen würde. Die Messstromquelle erzeugt zwar auch Verlustleistung, jedoch kann der Messstrom klein gewählt werden, um so die Verlustleistung zu minimieren.

In einer vorteilhaften Ausgestaltung ist die Stelleinrichtung digital schaltbar ausgebildet. D.h. ein Schalter, z.B. ein MOSFET wird z.B. über ein PWM-Signal an- und ausgeschaltet.

Weiterhin ist in dem Regelkreis ein Differenzverstärker zur Ermittlung einer Regelabweichung zwischen der Regelgrößenrückführung und einer Führungsgröße ausgebildet.

Außerdem sind ein Generator und ein Komparator zur Erzeugung der Stellgröße ausgebildet. Das Temperatursignal, welches aus dem Messsignal der Messeinrichtung erzeugt wird, wird in einem Fehlerverstärker von einer Sollwertvorgabe für die gewünschte Temperatur subtrahiert und verstärkt. Die verstärkte Abweichung wird in einem Komparator mit einem Modulationssignal, z.B. einem Dreieck- oder Sägezahn-Signal, welches in einem Generator erzeugt wird, verglichen. Das Vergleichsergebnis ist die Stellgröße zur Steuerung des Stellelementes und der Messeinrichtung. Die Stellgröße kann z.B. ein pulsbreiten-moduliertes Signal (PWM-Signal) sein.

Verfahrensseitig wird die Aufgabe der Erfindung dadurch gelöst, dass der Heizwiderstand mit einer gepulsten Spannung mit einer ersten Pulsdauer eines Ein-Zustandes und einer zweiten Pulsdauer eines Aus-Zustandes versorgt wird, wobei die erste und/oder die zweite Pulsdauer die Stellgröße des Regelkreises darstellen und dass der Heizwiderstand während der zweiten Pulsdauer mit einem Messstrom einer Konstant-Stromquelle beaufschlagt wird, wobei eine durch den Messstrom über dem Heizwiderstand erzeugte Spannung gemessen und als Regelgröße eingesetzt wird. Besonders vorteilhaft ist, dass die Messung der Spannung unabhängig und getrennt von der Versorgungsspannung V_{DD} gemessen wird. Damit ist das Messergebnis unbeeinflusst von einer nicht konstanten, d.h. schwankenden Versorgungsspannung. Unter einer schwankenden Versorgungsspannung V_{DD} ist eine Spannung zu verstehen, deren Gleichspannungswert zeitlich nicht konstant ist, sondern sich je nach Anwendungsfall ändert. Bei Anwendungen beispielsweise, die direkt Batteriebetrieben sind, ist die Batteriespannung abhängig vom Ladezustand. Auch Lastschwankungen, z.B. im Mobiltelefon bei ein- oder ausgeschaltetem Sender können Spannungsschwankungen auftreten. Die vorliegende Lösung bietet außerdem die Möglichkeit einen weiten Betriebsspannungsbereich, z.B. von 2.6V bis 3.6V abzudecken. Während einer ersten Pulsdauer (An-Zeit der Stelleinrichtung) wird der Heizwiderstand mit einer Energieversorgung verbunden, d.h. es wird eine Spannung angelegt und es fließt ein Strom durch den Heizwiderstand, wobei der Heizwiderstand dadurch erwärmt also geheizt wird. Während einer zweiten Pulsdauer (Aus-Zeit der Stelleinrichtung) wird der Heizwiderstand von der Energieversorgung getrennt und ist nun mit einer Stromquelle verbunden, so dass ein bekannter Messstrom durch den Heizwiderstand fließt, wobei zeitgleich mittels der Messeinrichtung der vom Messstrom erzeugte Spannungsabfall über dem Heizwiderstand gemessen wird. Zeitgleich bedeutet, dass in Abhängigkeit von dem Steuersignal für die Stelleinrichtung, die Messschaltung aktiviert oder deaktiviert wird. Während der An-Zeit ist die Messschaltung deaktiviert und während der Aus-Zeit ist die Messschaltung aktiviert und misst die Spannung über dem Heizwiderstand. Der durch den Messstrom hervorgerufene Spannungsabfall während der Aus-Zeit ist ein Maß für den Widerstandswert des Heizwiderstandes und damit ein Maß für die Temperatur des Sensorwiderstandes. Die Spannungsmessschaltung kann damit ein Signal erzeugen, welches der Temperatur des Heizwiderstandes und damit des Sensorwiderstandes entspricht, wobei die Messung entkoppelt von der nicht konstanten Versorgungsspannung der Anordnung zur Steuerung des Heizwiderstandes erfolgt. Dieses Signal stellt die Regelgröße in dem durch Stellelement und Messeinrichtung gebildeten Regelkreis dar, so dass damit durch die Ansteuerung der Stelleinrichtung, die Temperatur des Sensorwiderstandes exakt eingestellt werden kann.

Für das vorgeschlagenen Verfahren ist es wichtig, dass die Temperatur des Heizwiderstandes regelmäßig gemessen wird, um Temperaturabweichungen entgegenzusteuern. Dafür wird zwischen dem ersten und dem zweiten Schaltzustand mittels der Stelleeinrichtung periodisch umgeschaltet. Die Stelleinrichtung bewirkt, dass in einer An-Zeit der Stelleinrichtung der Heizwiderstand mit der Energieversorgung verbunden ist, d.h. eine Spannung an dem Heizwiderstand angelegt ist, die den Heizwiderstand erwärmt und in einer Aus-Zeit der Stelleinrichtung der Heizwiderstand mit der Stromquelle verbunden ist, so dass die Temperatur des Heizwiderstandes gemessen werden kann.

Die durch den Messstrom über dem Heizwiderstand gemessene Spannung ist ein Maß für eine Heiztemperatur des Heizwiderstandes und dient in dem erfindungsgemäßen Verfahren als Regelgröße, wobei die Regelgröße von einer Sollwertvorgabe subtrahiert wird und eine Abweichung in einem Verstärker verstärkt wird. Die Sollwertvorgabe richtet sich nach der Art des Halbleiter-Gassensors und dessen Einsatzgebiet. Je nachdem welches Sensorwiderstandsmaterial verwendet wird und welches Gas detektiert werden soll, ist eine exakte Temperatur des Sensorwiderstandes über den Heizwiderstand einzustellen. Durch die Regelung ist ein Nachführen der Sensortemperatur problemlos möglich.

Die Abweichung der Heiztemperatur und der Sollwertvorgabe für die Temperatur wird mit einem Modulationssignal mittels eines Komparators verglichen, wobei aus dem Vergleichsergebnis die Stellgröße zur Steuerung der Stelleinrichtung und der Messschaltung erzeugt wird. Die Stellgröße kann beispielsweise ein PWM-Signal sein. Dabei bilden eine Dauer des ersten Schaltzustandes und eine Dauer des zweiten Schaltzustandes ein Tastverhältnis m, wobei über das Tastverhältnis m eine im Heizwiderstand erzeugte Wärme eingestellt wird. Das Tastverhältnis, also der Anteil der An-Zeit zur Gesamtzeit, z.B. dieses pulsbreiten-modulierten Signals bestimmt die im Heizwiderstand erzeugte Wärme.

Die Erfindung soll nachfolgend anhand von Ausführungsbeispielen näher erläutert werden.

In den zugehörigen Zeichnungen zeigen die
- Fig. 1: Eine Ansteuerschaltung für den Heizwiderstand in einem Halbleiter-Gassensor für die Messung der Temperatur des Heizwiderstandes nach dem Stand der Technik;
- Fig. 2: eine erfindungsgemäße Treiberschaltungen für Heizwiderstände in einem Halbleiter-Gassensor;
- Fig. 3: Prinzip-Skizze eines klassischen Regelkreises;
- Fig. 4: eine erfindungsgemäße Treiber- und Messschaltung für Heizwiderstände in einem Halbleiter-Gassensor als Regelstrecke in einem Regelkreis.

Fig. 2 zeigt die erfindungsgemäße Treiber- und Messschaltung 100. Die Stelleeinrichtung 102, z.B. ein Transistor als Schalter, dient dazu, den Heizwiderstand 101 während einer ersten Pulsdauer (An-Zeit der Stelleinrichtung) mit der Energieversorgung zu verbinden, d.h. es wird eine Spannung angelegt und es fließt ein Strom durch den Heizwiderstand 101, der dadurch erwärmt also geheizt wird. Während einer zweiten Pulsdauer (Aus-Zeit der Stelleinrichtung) wird der Heizwiderstand 101 von der Energieversorgung getrennt bzw. wird durch die Verbindung mit einer Konstant-Stromquelle 103 überbrückt, wobei die Konstant-Stromquelle 103 einen bekannten Messstrom durch den Heizwiderstand 101 schickt, wobei in dieser Zeit mittels der Messeinrichtung 104 der vom Messstrom erzeugte Spannungsabfall über dem Heizwiderstand 101 gemessen wird. Der durch den Messstrom hervorgerufene Spannungsabfall während der Aus-Zeit ist ein Maß für den Widerstandswert des Heizwiderstandes 101 und damit ein Maß für die Temperatur des Sensorwiderstandes. Die Spannungsmessschaltung 104 kann damit ein Signal 106 erzeugen, welches der Temperatur des Heizwiderstandes 101 und damit der Temperatur des Sensorwiderstandes entspricht. Dieses Signal 106 stellt die Regelgröße in dem durch das Stellelement 102, die Messeinrichtung 104 und den Regler, welcher durch den Generator 111 und den Komparator 112 gebildet wird, gebildeten Regelkreis 200 dar, so dass damit durch die Ansteuerung des Stellelementes 102, die Temperatur des Sensorwiderstandes exakt einstellbar ist.

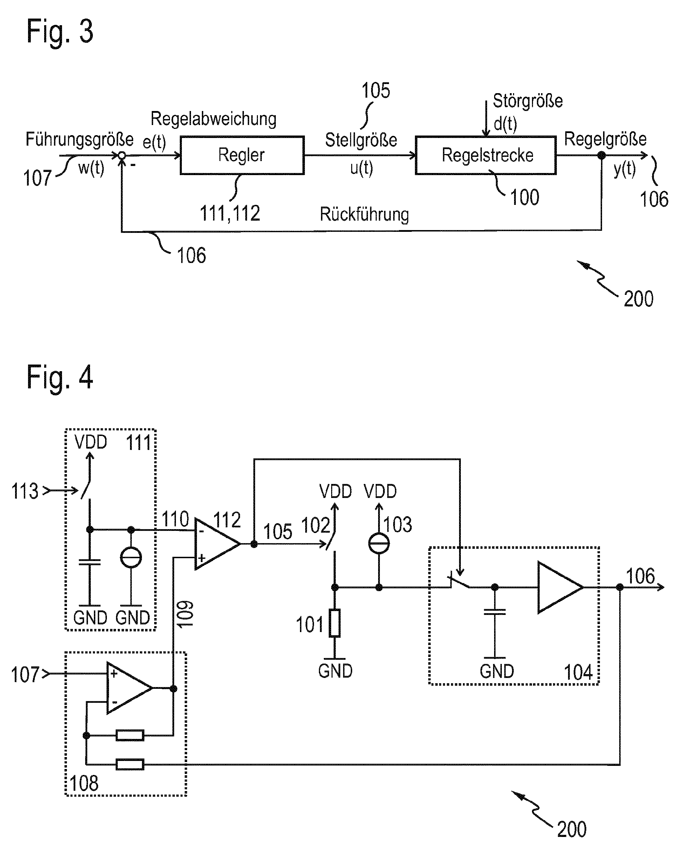

Figur 3 zeigt eine Prinzip-Skizze eines klassischen Regelkreises, insbesondere zur Veranschaulichung und Zuordnung der verwendeten Regelungstechnischen Begrifflichkeiten.

Figur 4 zeigt schematisch die erfindungsgemäße Anordnung zur Steuerung der Heiztemperatur in einem Halbleiter-Gassensor. Die Treiber- und Messschaltung entspricht exakt der in Figur 2 dargestellten. Das Temperatursignal 106, welches aus dem Messsignal der Messeinrichtung erzeugt wird, wird in einem Fehlerverstärker 108 von einer Sollwertvorgabe 107 für die gewünschte Temperatur subtrahiert und verstärkt. Die verstärkte Abweichung 109 wird in einem Komparator 112 mit einem Modulationssignal 110, z.B. einem Dreieck- oder Sägezahn-Signal, welches in einem Generator 111 erzeugt wird, verglichen. Das Vergleichsergebnis ist das pulsbreiten-modulierte Signal 105 (PWM-Signal) zur Steuerung des Stellelementes 102 und der Messeinrichtung 104.

### Bezugszeichenliste

- 100: Treiber- und Messschaltung
- 101: Heizwiderstand
- 102: Stellelement
- 103: Stromquelle
- 104: Messeinrichtung
- 105: PWM-Signal, Stellgröße
- 106: Signal für Temperaturmesswert, Spannungswert
- 107: Sollwertvorgabe
- 108: Differenzverstärker
- 109: Regelabweichung, d.h. verstärkte Abweichung zwischen Sollwert und Messwert
- 110: Modulationssignal
- 111: Generator zur Erzeugung eines Modulationssignals
- 112: Komparator
- 113: Eingangssignal für Modulationssignal
- 114: Messsignal für Heizstrom und Heizspannung
- 115: Messsignal für Heizstrom
- 116: Shunt-Widerstand zur Strommessung

- 200: Regelkreis

## Patentansprüche

1. Anordnung zur Steuerung der Heiztemperatur in einem Halbleiter-Gassensor umfassend einen Regelkreis, bestehend aus einem Heizwiderstand (101) als Regelstrecke (100) einer eine die Temperatur des Heizwiderstandes repräsentierende physikalische Größe messende Messeinrichtung (104), und einer eine Energieversorgung des Heizwiderstandes steuernde Stelleinrichtung (102), **dadurch gekennzeichnet, dass** die Stelleinrichtung (102) aus einer pulsierenden Spannungsquelle besteht, die eine erste Pulsdauer aufweist, während der der Heizwiderstand mit einer Betriebsspannung V_{DD} verbunden ist und einer zweiten Pulsdauer, während der der Heizwiderstand von der Betriebsspannung V_{DD} getrennt ist, deren erste und/oder zweite Pulsdauer als Stellgröße (105) steuerbar ist, und dass eine den Heizwiderstand (101) während der zweiten Pulsdauer mit einem Messstrom beaufschlagenden Konstant-Stromquelle (103) und eine die über den Heizwiderstand (101) infolge des Messstromes abfallende Messspannung messende Messeinrichtung (104) vorgesehen ist, deren Ausgang als Regelgrößenrückführung (106) in dem Regelkreis (200) ausgebildet ist.

2. Anordnung zur Steuerung der Heiztemperatur in einem Halbleiter-Gassensor nach Anspruch 1, **dadurch gekennzeichnet, dass** die Stelleinrichtung (102) digital schaltbar ausgebildet ist.

3. Anordnung zur Steuerung der Heiztemperatur in einem Halbleiter-Gassensor nach Anspruch 1, **dadurch gekennzeichnet, dass** in dem Regelkreis (200) ein Differenzverstärker (108) zur Ermittlung einer Regelabweichung (109) zwischen der Regelgrößenrückführung (106) und einer Führungsgröße (107) ausgebildet ist, sowie ein Generator (111) und ein Komparator (112) zur Erzeugung der Stellgröße (105) ausgebildet sind.

4. Verfahren zur Messung und Steuerung der Heiztemperatur eines Heizwiderstandes in einem Halbleiter-Gassensor, welches die Anordnung nach den Ansprüchen 1 bis 3 nutzt, wobei eine die Temperatur des Heizwiderstandes (101) repräsentierende physikalische Größe die Regelgröße (106) eines Regelkreises (200) darstellt, **dadurch gekennzeichnet, dass** der Heizwiderstand (101) mit einer gepulsten Spannung mit einer ersten Pulsdauer eines Ein-Zustandes und einer zweiten Pulsdauer eines Aus-Zustandes versorgt wird, wobei die erste und/oder die zweite Pulsdauer die Stellgröße (105) des Regelkreises (200) darstellen und dass der Heizwiderstand (101) während der zweiten Pulsdauer mit einem Messstrom einer Konstant-Stromquelle (103) beaufschlagt wird, wobei eine durch den Messstrom über dem Heizwiderstand erzeugte Spannung (106) gemessen und als Regelgröße eingesetzt wird.

5. Verfahren zur Messung und Steuerung der Heiztemperatur eines Heizwiderstandes in einem Halbleiter-Gassensor nach Anspruch 4, **dadurch gekennzeichnet, dass** zwischen dem ersten und dem zweiten Schaltzustand mittels eines Stellelementes (102) periodisch umgeschaltet wird.

6. Verfahren zur Messung und Steuerung der Heiztemperatur eines Heizwiderstandes in einem Halbleiter-Gassensor nach Anspruch 5, **dadurch gekennzeichnet, dass** die durch den Messstrom über dem Heizwiderstand erzeugte Spannung (106) von einer Sollwertvorgabe (107) subtrahiert wird und eine Abweichung (109) in einem Verstärker (108) verstärkt wird.

7. Verfahren zur Messung und Steuerung der Heiztemperatur eines Heizwiderstandes in einem Halbleiter-Gassensor nach Anspruch 6, **dadurch gekennzeichnet, dass** die Abweichung (109) der Heiztemperatur (106) und der Sollwertvorgabe (107) mit einem Modulationssignal (110) mittels eines Komparators (112) verglichen wird, wobei aus dem Vergleichsergebnis die Stellgröße (105) zur Steuerung der Stelleinrichtung (102) und der Messschaltung (104) erzeugt wird.

8. Verfahren zur Messung und Steuerung der Heiztemperatur eines Heizwiderstandes in einem Halbleiter-Gassensor nach Anspruch 7, **dadurch gekennzeichnet, dass** die Stellgröße (105) ein PWM-Signal ist.

9. Verfahren zur Messung und Steuerung der Heiztemperatur eines Heizwiderstandes in einem Halbleiter-Gassensor nach Anspruch 6, **dadurch gekennzeichnet, dass** eine Dauer des ersten Schaltzustandes und eine Dauer des zweiten Schaltzustandes ein Tastverhältnis m bilden, wobei über das Tastverhältnis m eine im Heizwiderstand (101) erzeugte Wärme eingestellt wird.
